Europäisches Patentamt

European Patent Office

Office européen des brevets

(11) Publication number: **0 269 335 B1**

# EUROPEAN PATENT SPECIFICATION

(45) Date of publication of patent specification: **08.07.92** (51) Int. Cl.⁵: **H01L 31/10**

(21) Application number: **87310084.6**

(22) Date of filing: **16.11.87**

(54) **Radiation-sensitive device.**

(30) Priority: **24.11.86 US 933913**

(43) Date of publication of application:
**01.06.88 Bulletin 88/22**

(45) Publication of the grant of the patent:
**08.07.92 Bulletin 92/28**

(84) Designated Contracting States:
**DE FR GB IT NL**

(56) References cited:
**EP-A- 0 165 764**
**GB-A- 2 107 860**
**US-A- 3 569 704**

**PATENT ABSTRACTS OF JAPAN, vol. 10, no.
72 (P-438)[2129], 22nd March 1986 & JP-A-60
211 385**

**IEEE TRANSACTIONS ON NUCLEAR SCI-
ENCE, vol. NS-31, no. 6, December 1984,
pages 1113-1115, IEEE, New York, US; L.S.
AUGUST et al.: "Advantages of using a
PMOS fet dosimeter in high-dose radiation
effects testing"**

(73) Proprietor: **AMERICAN TELEPHONE AND
TELEGRAPH COMPANY
550 Madison Avenue
New York, NY 10022(US)**

(72) Inventor: **William, Thomas Lynch
72 Passaic Avenue
Summit New Jersey 07901(US)**
Inventor: **Lalita, Manchanda
21H Regency Village
North Plainfield New Jersey 07060(US)**

(74) Representative: **Watts, Christopher Malcolm
Kelway, Dr. et al
AT&T (UK) LTD. AT&T Intellectual Property
Division 5 Mornington Road
Woodford Green Essex IG8 OTU(GB)**

## Description

### Background of the Invention

This invention relates to measuring radiation and, more particulary, to a semiconductor device for measuring low-level doses of ionizing radiation.

In a number of medical, military and other applications, it is important to be able to measure the dose of ionizing radiation to which an animate or inanimate object is exposed. Ideally, the instrumentality utilized to measure dosage should be low in cost, reliable and sensitive.

Detecting radiation at low levels (for example, radiation in the range of 10-to-100 rads) requires a particularly sensitive device. (A rad is a unit of radiation dose equal to the quantity of ionizing radiation that results in the absorption of 100 ergs of energy per gram of irradiated material.)

Devices of the metal-oxide-semiconductor (MOS) type have been suggested for use as radiation detectors. But, heretofore, in practice the sensitivity of such devices has generally been insufficient to enable them to be employed as effective radiation detectors in the aforespecified low-level range.

A dosimeter as set out in the preamble of claim 1 is disclosed in GB-A-2107860.

### Summary of the Invention

According to the invention a dosimeter and a method as set out in the claims can be used for measuring low-level doses of ionizing radiation.

The dosimeter includes a p-channel depletion-mode MOS transistor. Illustratively, the transistor is fabricated in a process sequence designed to achieve a relatively high density of hole traps in the gate oxide thereof. Advantageously, the efficiency of trapping holes in the oxide is enhanced by utilizing n + polysilicon for the material of the gate electrode that overlies the oxide. Further, in one embodiment the transistor comprises a simple ring-gate design which includes no field oxide and is relatively easy to make.

### Brief Description of the Drawing

Some embodiments of the invention will now be described by way of example with reference to the accompanying drawing, not drawn to scale, in which:

FIG. 1 is a schematic representation of a specific illustrative MOS device made in accordance with the present invention; and

FIGS. 2 and 3 are side and top views, respectively, of a specific illustrative ring-gate MOS device that embodies the invention.

### Detailed Description

An MOS device can be used to detect and measure low-level doses of ionizing radiation (for example, gamma rays or X-rays in the range of approximately 10-to-100 rads). Radiation incident on such a device causes a negative-direction change in the gate threshold voltage thereof, as is well known in the art. We have found that, for a given dose of radiation, the change in threshold voltage in a p-channel device is greater than that in an n-channel device.

The aforementioned change in threshold voltage in an MOS device arises from radiation-generated electron/hole pairs created in the gas oxide of the device. Electrons have considerably greater mobility in the oxide than do holes. In practice, radiation-generated electrons that escape initial recombination move in a matter of picoseconds to the conductive gate electrode that overlies the oxide. This leaves behind in the oxide a number of radiation-generated holes. Some of these holes are immobilized in the oxide by being trapped in hole-trap sites and, also, in donor-type interface states which are created by the incident radiation itself. It is these trapped holes or positive charges that cause a shift in the threshold voltage of the device.

Preferably the density of hole traps in the gate oxide of a p-channel MOS device is purposely enhanced during fabrication. (The particular ways in which this is done will be specified later below.) As a result, the likelihood of trapping radiation-generated holes in the oxide is increased. Consequently, for a given radiation dose, the shift in threshold voltage is greater than it would be without such enhancement. Importantly, the sensitivity of the device is thus improved.

Trapping of radiation-generated holes in an MOS device is most likely to occur in the vicinity of the interface that exists between the gate oxide and the underlying silicon surface. This is so because the density of hole-trap sites and donor-type interface states is greatest in this vicinity.

The likelihood of trapping holes in the gate oxide of the device can accordingly be further enhanced by deliberately establishing therein a field that tends to move the holes towards the interface.

Thus, the aforementioned p-channel MOS detector is designed to be a depletion-mode device. Such a device operates with a positive bias voltage applied to the gate electrode thereof. Significantly, this positive bias particularly enhances the radiation sensitivity of the specified device.

Preferably, the gate electrode of the p-channel depletion-mode device comprises $n^+$-type polysilicon (rather than $p^+$-type polysilicon or a metal). The use of $n^+$-type polysilicon ensures that a relatively large positive electric field will exist in the gate oxide even in the absence of an external positive bias voltage connected to the gate electrode. This field is effective to move holes towards the gate oxide-to-silicon interface and thus to enhance the radiation sensitivity of the device.

Accordingly, such devices can serve as effective radiation detectors in a variety of both on-line and off-line applications. For on-line applications, the device is operated with a positive bias voltage applied to the gate electrode and a negative bias voltage connected to the drain of the device. For a particular applied gate voltage, the change in drain current between the no-incident-radiation case and the case in which the device has been subjected to radiation is measured. This current change, which arises from a change in gate threshold voltage, is a direct indicator of incident radiation dose.

For off-line applications, applicants' device is exposed to radiation without any bias voltages applied thereto. (Prior to exposure, the drain current of the device is measured at a selected gate voltage.) After exposure, the change if any in drain current, at the same selected gate voltage, is a direct indicator of incident radiation dose.

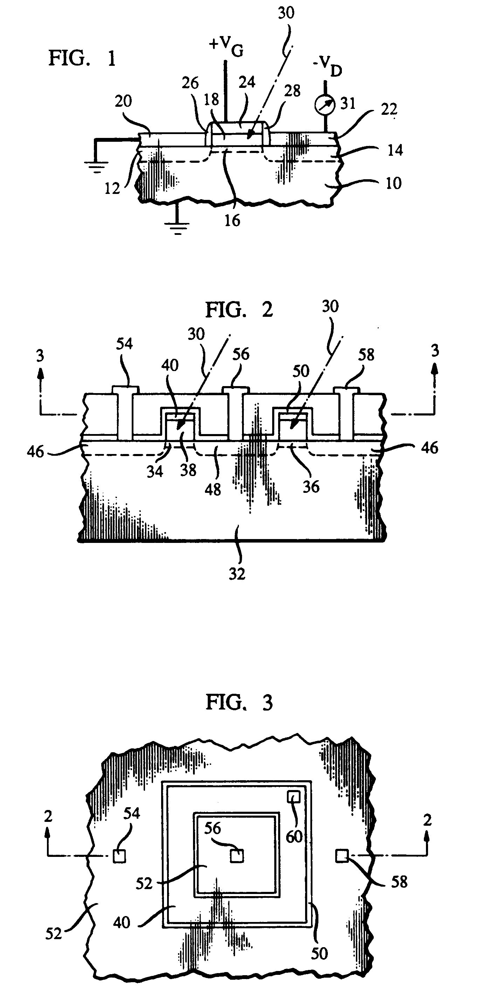

By way of a specific illustrative example, FIG. 1 schematically shows in cross-section a portion of a p-channel depletion-mode MOS device.

The depicted device may constitute a single discrete unit or be part of an integrated-circuit assembly. In the latter case, additional associated circuitry (not shown) is formed in the same wafer substrate in which the device is made.

The p-channel depletion-mode MOS device shown in FIG. 1 comprises an n-type silicon substrate 10 having $p^+$ source and drain regions 12 and 14, respectively, formed therein. The substrate 10 also includes a p-type channel region 16 extending between the regions 12 and 14.

Disposed on the top surface of the substrate 10 of FIG. 1 are a gate oxide portion 18 and conductive portions 20 and 22 made, for example, of a metal or doped polysilicon. A conductive portion 24 overlies the gate oxide portion 18. Advantageously, as discussed earlier above, the conductive portion 24 comprises $n^+$-type polysilicon. The portions 20,22 and 28 comprise the source, drain and gate electrodes, respectively, of the depicted device.

Further, nonconductive spacer portions 26 and 28 are disposed on the sides of the gate oxide portion 18 and the gate electrode 24 of FIG. 1. By way of example, the portions 26 and 28 are made of undoped silicon dioxide.

Radiation incident on the FIG. 1 device is represented by dash line 30. As discussed earlier above, such radiation causes electron/hole pairs to be generated in the gate oxide portion 18.

Illustratively, the FIG. 1 device is shown connected to associated bias voltages for operation in the aforementioned on-line mode. Specifically, a positive direct-current voltage designed $+V_G$ is indicated as being connected to the gate electrode 24 and a negative direct-current voltage designed $-V_D$ is shown connected to the drain electrode 22. Additionally, the source electrode 20 and the substrate 10 are shown connected to a point of reference potential such as ground. Drain current is measured by ammeter 31.

One advantageous embodiment of applicants' invention comprises a p-channel depletion-mode MOS device of the ring-gate type. Such a device design is relatively easy to make and well-suited to serve as the basis for an inexpensive discrete detector. A specific illustrative embodiment of such a ring-gate radiation detector is depicted in FIGS. 2 (cross-sectional side view) and 3 (top view).

A significant advantage of the device represented in FIGS. 2 and 3 is that it can be made relatively easily and inexpensively. Specifically, as will be detailed below, the depicted device can be fabricated utilizing only three masks.

Also, the ring-gate device does not require a field-oxide layer which itself could be a major trapper of holes. In practice, the presence of a field-oxide layer in the measuring device can deleteriously affect the accuracy and sensitivity of radiation-dose measurements.

The specific illustrative fabrication sequence described below for making a ring-gate device includes steps for achieving an enhancement, in the density of hole traps in the gate oxide thereof.

FIG. 2 shows a conventional n-type silicon substrate 32 commonly employed to make MOS devices.

The first step involved in processing the substrate 32 to form a ring-gate device therein is to implant p-type ions such as boron ions into the entire top surface of the substrate to establish a relatively shallow p-type zone therein. Regions 34 and 36 in FIG. 2 comprise spaced-apart portions of that p-type zone.

Next a relatively thick layer of silicon dioxide is grown on the entire top surface of the substrate 32 shown in FIG. 2. Illustratively, this layer is designed to be about 100-500 nm (1000-to-5000 Å) thick. In accordance with applicants' invention, it is advantageous to establish a relatively high density of hole traps in this layer. By way of example, this is achieved by growing the oxide at a temperature of approxiamtely 1000-to-1100 degrees Celsius (C) and then annealing the grown oxide in argon at a temperature of about 1000-to-1100 degrees C.

Subsequently, a layer of $n^+$-doped polysilicon about 250 nm (2500 Å) thick is deposited overlying the entire top surface of the aforedescribed gate oxide layer. Illsutratively, the polysilicon layer is annealed at a temperature of about 950 degrees C.

In the first processing step that requires a mask, the polysilicon/oxide layers on the substrate 32 of FIG. 2 are then selectively etched in conventional ways to define a ring-type gate pattern therein. This pattern comprises a closed ring including gate oxide portion 38 with an overlying $n^+$-polysilicon portion 40, as shown in FIG. 2.

Source/drain regions are then formed in the FIG. 2 structure by, for example, implanting p-type ions such as boron ions into the surface portions of the substrate 32 that are not masked by the aforedescribed gate pattern. After annealing at a temperature of about 950 degrees C, these regions comprise source region 46 and drain region 48 which are shown in FIG. 2.

Next, a layer of a suitable dielectric material such as undoped silicon dioxide is deposited on the exposed portions of the top surface of the substrate 32 and on the sides and tops of the gate pattern shown in FIG. 2. Illustratively, this dielectric layer is about 100-500 nm (1000-to-5000 Å) thick. This layer, with later-formed windows included therein, is designated in FIG. 2 by reference numeral 50.

In further accord with applicants' fabrication sequence, the layer 50, without windows yet formed therein, is then covered with a deposited layer of, for example, p-doped silicon dioxide (p-glass) about one micrometer thick. To enhance the radiation sensitivity of the depicted device, it is advantageous to anneal the p-glass layer. Illustratively, annealing is carried out in a hydrogen atmosphere for about one hour at a temperature of approximately 500-to-700 degrees C.

In a step that requires another (the second) mask, source/drain contact windows or apertures are then etched through the p-glass layer and the underlying layer 50. The resulting apertured p-glass layer 52 is shown in FIG. 2.

In the same step in which source/drain contact windows are formed in the p-glass layer 52, a contact window (not shown in FIG. 2) is also etched in the layer 52 to expose an underlying part of the $n^+$-polysilicon layer 40. A suitable conductive material such as aluminum is then deposited in the contact windows and on the top surface of the p-glass layer 52. Patterning of the conductive material, utilizing another mask (the third mask of the fabrication sequence), is then carried out. The resulting portions of the conductive pattern that contact the source/drain regions are designated 54, 56 and 58 in FIG. 2. The portion of the conductive pattern that contacts the $n^+$-polysilicon layer 40 of the gate pattern is designated 60 in the top view of FIG. 3.

The undoped silicon dioxide layer 50 around the gate pattern shown in FIG. 2 serves as a blocking layer. Specifically, the layer 50 serves to prevent phosphorus in the p-glass layer 52 from migrating into the gate oxide portion 38. If such movement occurred, the efficiency of trapping holes in surface regions of the gate oxide portion 38 could be affected and, as a result, the relationship between incident radiation and threshold-voltage change could be made less predicable. In turn, the measurement of radiation dose could be thereby made less accurate.

Other materials exhibiting advantageous hole trapping properties may be substituted for the silicon dioxide material utilized to form the gate portion 18 (FIG. 1) and the gate portion 38 (FIG. 2). An illustrative such substitute material comprises semi-insulating polycrystalline silicon (SIPOS).

## Claims

1. A radiation dosimeter comprising
   a p-channel MOS transistor adapted to be interposed in the path of ionizing radiation,
   CHARACTERISED IN THAT
   the transistor is a depletion-mode transistor
   and by means for determining, for a given gate voltage applied to said device, the change in source-to-drain current that results from irradiation of said transistor by said ionizing radiation thereby to provide a measurement of the radiation dose to which said device was exposed.

2. A dosimeter as in claim 1 wherein said device comprises a gate structure including an insulating gate layer (18) having a conductive gate layer (24) thereon, said conductive gate layer comprising n + polysilicon.

3. A dosimeter as in claim 2 wherein said insulating gate (18) layer comprises silicon dioxide.

4. A dosimeter as in claim 2 wherein said insulating gate (18) layer comprises semi-insulating polycrystalline silicon.

5. A dosimeter as in any of the preceding claims wherein said device comprises a gate structure having a closed ring structure (38, 40).

6. A method of measuring ionizing radiation dose, comprising the step of
   interposing a p-channel MOS transistor in the path of radiation whose dose is to be measured,
   CHARACTERISED BY
   for a given gate voltage, measuring the change in drain current that occurs in said transistor as a result of being irradiated, the transistor being a depletion-mode transistor.

7. A method as in claim 6 wherein said transistor comprises source and drain contacts (20, 22) and a gate structure that includes an insulating gate layer (18) having an $n^+$ polysilicon layer (24) thereon,

and, wherein during the time that said transistor is exposed to radiation, an external positive bias voltage is connected to said n + polysilicon layer and an external negative bias voltage is applied to said drain contact.

8. A method as in claim 6 wherein said transistor comprises source and drain contacts (20, 22) and a gate structure that includes an insulating gate layer (18) having an $n^+$ polysilicon layer (24) thereon,

wherein during the time that said transistor is exposed to radiation, no external bias voltages are applied to said transistor

and wherein, before and after exposure, an external positive bias voltage is connected to said $n^+$ polysilicon layer and an external negative bias voltage is applied to said drain contact and the respective corresponding source-to-drain currents are compared.

**Revendications**

1. Un dosimètre de rayonnement comprenant :

un transistor MOS à canal p conçu pour être interposé sur le trajet d'un rayonnement ionisant,

CARACTERISE EN CE QUE

le transistor est un transistor à mode de désertion

et des moyens sont prévus pour déterminer, pour une tension de grille donnée appliquée au transistor, la variation du courant source-drain qui résulte de l'irradiation du transistor par le rayonnement ionisant, pour fournir ainsi une mesure de la dose de rayonnement à laquelle le transistor a été exposé.

2. Un dosimètre selon la revendication 1, dans lequel le transistor comprend une structure de grille comportant une couche de grille isolante (18) sur laquelle est formée une couche de grille conductrice (24), cette couche de grille conductrice consistant en silicium polycristallin de type $n^+$.

3. Un dosimètre selon la revendication 2, dans lequel la couche de grille isolante (18) consiste en dioxyde de sillcium.

4. Un dosimètre selon la revendication 2, dans lequel la couche de grille isolante (18) consiste en silicium polycristallin semi-isolant.

5. Un dosimètre selon l'une quelconque des revendications précédentes, dans lequel le transistor comprend une structure de grille qui présente une structure d'anneau fermé (38, 40).

6. Un procédé de mesure d'une dose de rayonnement ionisant, comprenant l'étape qui consiste à

interposer un transistor MOS à canal p dans le trajet du rayonnement dont on doit mesurer la dose,

CARACTERISE EN CE QUE

pour une tension de grille donnée, on mesure la variation du courant de drain qui se produit dans le transistor sous l'effet de son irradiation, le transistor étant un transistor à mode de désertion.

7. Un procédé selon la revendication 6, dans lequel le transistor comprend des contacts de source et de drain (20, 22) et une structure de grille qui comprend une couche de grille isolante (18) sur laquelle est formée une couche de silicium polycristallin de type $n^+$ (24),

et dans lequel pendant la durée au cours de laquelle le transistor est exposé au rayonnement, une tension de polarisation positive externe est appliquée à la couche de silicium polycristallin de type $n^+$ et une tension de polarisation négative externe est appliquée au contact de drain.

8. Un procédé selon la revendication 6, dans lequel le transistor comprend des contacts de source et de drain (20, 22) et une structure de grille qui comprend une couche de grille isolante (18) sur laquelle est formée une couche de silicium polycristallin de type $n^+$ (24),

dans lequel, pendant la durée au cours de laquelle le transistor est exposé au rayonnement, aucune tension de polarisation externe n'est appliquée à ce transistor,

et dans lequel, avant et après l'exposition, une tension de polarisation positive externe est appliquée à la couche de silicium polycristallin de type $n^+$ et une tension de polarisation négative externe est appliquée au contact de drain, et on compare les courants source-drain correspondants respectifs.

**Patentansprüche**

1. Strahlungsdosimeter mit einem p-Kanal-MOS-Transistor, der dazu ausgelegt ist, in den Strahlengang ionisierender Strahlung gebracht zu werden,
dadurch gekennzeichnet, daß der Transistor ein Verarmungstransistor ist und daß eine Einrichtung vorgesehen ist, um für eine an den Transistor angelegte, vorgegebene Gatespannung die Änderung des Stromes von Source nach Drain zu bestimmen, die sich aus der Bestrahlung des Transistors durch die ionisierende Strahlung ergibt, um dadurch die Strahlendosis, der der Transistor ausgesetzt war, zu messen.

2. Ein Dosimeter nach Anspruch 1,
dadurch gekennzeichnet, daß der Transistor eine Gatestruktur besitzt, bei der eine leitende Gateschicht (24) auf einer isolierenden Gateschicht (18) angeordnet ist, wobei die leitende Gateschicht (24) $n^+$ Polysilizium enthält.

3. Ein Dosimeter nach Anspruch 2,
dadurch gekennzeichnet, daß die isolierende Gateschicht (18) Siliziumdioxid enthält.

4. Ein Dosimeter nach Anspruch 2,
dadurch gekennzeichnet, daß die isolierende Gateschicht (18) halbisolierendes polykristallines Silizium enthält.

5. Ein Dosimeter nach einem der vorhergehenden Ansprüche,
dadurch gekennzeichnet, daß der Transistor eine Gatestruktur in Form einer geschlossenen Ringstruktur (38, 40) besitzt.

6. Ein Verfahren zur Messung der Dosis ionisierender Strahlung, bei dem ein p-Kanal-MOS-Transistor in den Strahlengang der zu messenden Strahlung gebracht wird,
dadurch gekennzeichnet, daß bei einem Verarmungstransistor bei gegebener Gatespannung die Veränderung des Drainstromes gemessen wird, die infolge der Bestrahlung in dem Transistor auftritt.

7. Ein Verfahren nach Anspruch 6,
dadurch gekennzeichnet, daß der Transistor Source- und Drainkontakte (20, 22) und eine Gatestruktur besitzt, die eine $n^+$ Polysiliziumschicht (24) auf einer isolierenden Gateschicht (18) enthält, und daß während der Zeit, in der der Transistor der Strahlung ausgesetzt ist, eine äußere positive Vorspannung an die $n^+$ Polysiliziumschicht (24) und eine äußere negative Vorspannung an den Drainkontakt (22) angelegt wird.

8. Ein Verfahren nach Anspruch 6,
dadurch gekennzeichnet, daß der Transistor Source- und Drainkontakte (20, 22) und eine Gatestruktur besitzt, die eine $n^+$ Polysiliziumschicht (24) auf einer isolierenden Gateschicht (18) enthält, daß während der Zeit, in der der Transistor der Strahlung ausgesetzt ist, keine externen Vorspannungen an den Transistor angelegt werden und daß vor und nach dieser Zeitspanne eine äußere positive Vorspannung an die $n^+$ Polysiliziumschicht (24) und eine äußere negative Vorspannung an den Drainkontakt (22) angelegt und die jeweiligen Source-nach-Drain-Ströme miteinander verglichen werden.

FIG. 1

FIG. 2

FIG. 3